# EUROPÄISCHE PATENTSCHRIFT

(11) **EP 3 217 186 B1**
(45) Veröffentlichungstag und Bekanntmachung des Hinweises auf die Patenterteilung: **11.07.2018**
(21) Anmeldenummer: 17158984.9
(22) Anmeldetag: 02.03.2017
(51) Int. Cl.: G01R 33/383, G01R 33/389

(54) **STREUFELDARME PERMANENTMAGNETANORDNUNG FÜR MR-APPARATUREN**
LOW FRINGE FIELD PERMANENT MAGNET FOR MR APPARATUS
AIMANT PERMANENT IRM A CHAMP DE FRANGES REDUIT

(30) Priorität: 04.03.2016 DE 102016203588
(43) Veröffentlichungstag der Anmeldung: 13.09.2017
(73) Patentinhaber: Bruker BioSpin GmbH, 76287 Rheinstetten (DE)
(72) Erfinder: Hänichen, Lukas, 76137 Karlsruhe (DE); Pietig, Rainer, 76316 Malsch (DE)
(74) Vertreter: Kohler Schmid Möbus Patentanwälte

(56) Entgegenhaltungen:
- US-B2- 7 084 633
- US-B2- 7 148 777
- US-B2- 8 077 002

## Beschreibung

Die Erfindung betrifft eine Magnetanordnung für eine Magnetresonanz-Apparatur mit einem Permanentmagnetsystem zur Erzeugung eines homogenen Magnetfeldes in Richtung einer z-Achse in einem Messvolumen, wobei das Permanentmagnetsystem bezüglich der z-Achse zylindersymmetrisch angeordnete Magnetelemente, Polschuhelemente und Jochelemente aus magnetischem Material aufweist.

Eine solche Magnetanordnung ist bekannt aus der US 7,084,633 B2.

### Hintergrund der Erfindung

Die vorliegende Erfindung betrifft allgemein den Bereich der Magnetresonanz, insbesondere die Bereitstellung von hierfür geeigneten Permanentmagnetsystemen, die zur Erzeugung von homogenen Magnetfeldern für NMR-Messungen bestimmt sind. Die Anwendbarkeit der Erfindung ist jedoch nicht auf dieses Gebiet beschränkt.

Die Magnetresonanz (einschließlich Kernspinresonanz, abgekürzt "NMR" und einschließlich Elektronenspinresonanz, abgekürzt "EPR") ist eine weit verbreitete Messmethode, mit der chemische Verbindungen analysiert werden können. Sowohl im Bereich der Kernresonanzspektroskopie (NMR spectroscopy) als auch bei der bildgebenden Anwendung (MR imaging) wird in einem zu definierenden Probenvolumen ein sehr homogenes und zeitlich konstantes Magnetfeld benötigt, welches mit resistiven oder supraleitenden Spulen oder einer geeigneten Permanentmagnetanordnung erzeugt werden kann. Die Verwendung von Permanentmagneten wird bevorzugt, wenn Flussdichten von deutlich unterhalb 2T ausreichend sind und ein vergleichsweise kompakter Aufbau erwünscht ist.

Um den magnetischen Fluss im Probevolumen zu maximieren und damit gleichzeitig den Streufluss zu minimieren muss der magnetische Fluss gebündelt werden. Es wird dabei zwischen Magnetkreisen unterschieden, wo der magnetische Rückschluss durch ein Joch aus einem weichmagnetischem Werkstoff realisiert ist, oder solchen Magnetkreisen, die ohne Joch auskommen. Bei Letzteren handelt es sich meist um Abwandlungen sogenannter Halbach Magnete, wo der Rückfluss durch eine graduelle Änderung der Magnetisierungsrichtung vereinfacht wird. In der Praxis wird eine Halbach Anordnung typischerweise durch eine stufenweise Änderung der Magnetisierungsrichtung erzielt. Diese Abweichung von der idealen Halbach Magnetisierung trägt zu einer Erhöhung des Streufeldes außerhalb der eigentlichen Magnetanordnung bei und macht für streufeldfreie Anwendungen eine zusätzliche Abschirmung erforderlich. Bei jochbasierten Magneten kann durch geschicktes Jochdesign und Einsatz des Jochmaterials deutlich unterhalb der Sättigungsflussdichte eine ausreichende Abschirmung des Streufeldes erzielt werden.

Die Permanentmagnete werden typischerweise von einer Stützstruktur gehalten, die zusätzlich die Funktion des magnetischen Rückschlusses erfüllen kann. Traditionelle Bauformen verfügen über ein Joch in Form eines rechteckigen Rahmens (Windowframe, H-Joch, C-Joch), mit zwei gegenüberstehenden zentralen Magnetbaugruppen, zwischen denen sich das Probenvolumen befindet. Auch diese Jochbauformen sind durch ihre offene Bauweise meist mit Streufeldern behaftet, die sich weit über die Außenkonturen der Magnetanordnung ausdehnen.

Um die für NMR-Messungen geforderte Feldhomogenität im Probenvolumen zu erreichen, müssen bei den jochfreien Halbach-Magneten Korrekturmechanismen vorgesehen werden, um Toleranzen des Magnetmaterials oder der Position der einzelnen Magnetblöcke ausgleichen zu können, was den mechanischen Aufbau verkompliziert. Jochbasierte Magnete besitzen in der Regel ein paralleles Polschuhpaar aus einem weichmagnetischen Werkstoff mit entsprechend hoher Sättigungsflussdichte. Durch geeignete Wahl der Polschuhgeometrie und spezielle Oberflächenbearbeitung kann das Feldprofil auf vergleichsweise einfache und effiziente Weise optimiert werden.

### Spezieller Stand der Technik

Die US 8,077,002 B2 offenbart eine Permanentmagnetvorrichtung für MRI-Anwendungen. Es geht um ein Paar massiver scheibenartiger Magnete, die den Luftspalt als Symmetrieebene parallel begrenzen und jeweils einen versetzten (vorstehenden) Ringmagneten umfassen, sodass ein L-förmiger Magnet entsteht. Polschuhe sind beiderseits des Luftspalts angeordnet zur Parallelausrichtung des Magnetfelds im Luftspalt. Die sogenannte L-Magnetanordnung wird durch ein T-Joch bestehend aus den Bauteilen 114a,b und 110a,b gehalten. Da es sich bei der vorliegenden Magnetanordnung um eine offene Struktur handelt ist dieses T-Joch konstruktionsbedingt erforderlich. Die beschriebenen T-Jochstränge sind durch einen zusätzlichen Steg als magnetischem Rückschluss verbunden.

Die eingangs zitierte US 7,084,633 B2 offenbart eine Magnetanordnung für MRT-Geräte unter Verwendung von Permanentmagneten. Die Permanentmagnete sind derart angeordnet, dass ein Paar von zentralen Permanentmagneten mit jeweils einem Polschuh verbunden sind, in deren Zwischenraum sich das Messvolumen befindet. Die Magnetisierung der beiden Magnete ist in die gleiche Richtung orientiert, sodass der Magnetfluss in eine definierte Richtung durch das Messvolumen fließt. Um die besagten Magnete herum sind weitere Segmente von Permanentmagneten kreisförmig angeordnet wobei die Magnetisierungsrichtung der Magnete radial nach außen bzw. radial nach innen gerichtet ist, sodass das Magnetfeld innerhalb den Messvolumens verstärkt wird. Als Joch, zur Rückführung des Magnetfelds sind Platten aus ferromagnetischem Material angeordnet. Aus Konstruktionsgründen und zur Führung des magnetischen Flusses der Ecksegmente sind Stützjoche an den jeweiligen Ecken erforderlich.

Sämtliche bekannten Permanentmagnetsysteme für die Magnetresonanz weisen jedoch die folgenden, teilweise gravierenden Nachteile auf:
- Erzeugung eines erheblichen magnetischen Streufelds im Außenraum der MR-Apparatur
- Systembedingte großvolumige Bauweise der bekannten Permanentmagnetsysteme und mithin großer Platzbedarf sowie hoher Materialaufwand
- Leichte Verschiebbarkeit der Bauteile des System relativ zueinander aufgrund der hohen auftretenden Magnetkräfte und dadurch Probleme beim Dauerbetrieb beziehungsweise aufwändige konstruktive Maßnahmen zur sicheren Verhinderung einer Verschiebung.

Zum letztgenannten Punkt ist zu bemerken, dass die Hersteller bei bekannten Bauformen teilweise einen erheblichen Extraaufwand betreiben (müssen), um dafür zu sorgen, dass sich mit Sicherheit nichts verschiebt. Das erfordert konstruktive Maßnahmen -etwa Verstärkungen, Stützen etc.- welche die Konstruktion in der Regel erheblich schwerer und größer machen. Eine Verschiebung einzelner Baugruppen, kann die Homogenität des Magnets verschlechtern oder schlimmstenfalls Gegenstände im Probenvolumen gefährden (Quetschgefahr). Nicht zuletzt können bewegliche Baugruppen auch während der Montage zu einem Problem werden, z.B. weil da noch Gehäuseelemente unvollständig sind.

### Aufgabe der Erfindung

Der vorliegenden Erfindung liegt demgegenüber die Aufgabe zugrunde, in einer Permanentmagnetanordnung der eingangs definierten Art mit einfachen technischen Maßnahmen und ohne Volumenzunahme der Magnetanordnung das magnetische Streufeld im Außenraum wesentlich zu reduzieren, wobei die Dauerbetriebssicherheit des Systems gegenüber mechanischen Verschiebungen von Bauteilen im Betrieb deutlich gesenkt und das System insgesamt erheblich kompakter gestaltet werden soll.

### Kurze Beschreibung der Erfindung

Diese Aufgabe wird durch die vorliegende Erfindung auf ebenso überraschend einfache wie wirkungsvolle Weise dadurch gelöst, dass die Jochelemente einen ersten Deckel und einen zweiten Deckel sowie mindestens eine in axialer Richtung bezüglich der z-Achse zwischen den Deckeln angeordnete hohlzylindrische Trommel umfassen, wobei die Jochelemente das Messvolumen sowohl in axialer als auch in radialer Richtung umschließt, und dass die Magnetelemente mindestens ein Paar von zylindersymmetrischen Axialmagneten sowie ein Paar von zylindersymmetrischen Radialmagnetringen umfassen, wobei die Axialmagnete jeweils an die dem Messvolumen zugewandte Seite des ersten Deckels beziehungsweise des zweiten Deckels in axialer Richtung anschließend angeordnet sind, wobei die Radialmagnetringe jeweils an die dem Messvolumen zugewandte Seite des ersten Axialmagneten beziehungsweise des zweiten Axialmagneten in axialer Richtung anschließend angeordnet sind, und wobei gilt:
Außendurchmesser der Axialmagnete ≤ Innendurchmesser der Radialmagnetringe.

Ein solches das Messvolumen umschließendes Joch reduziert das Streufeld erheblich. Durch die geschlossene Jochbauweise aus Mantel und Deckel (bis auf die unten beschriebenen seitlichen Zugangsöffnungen) ist das Streufeld im Außenraum praktisch vernachlässigbar.

Die magnetischen Bauteile sind durch den erfindungsgemäßen Aufbau gegen unerwünschte Bewegungen gesichert. Auf Grund der neuartigen geometrischen Form der Bauteile sowie des Jochs hindern sich benachbarte Bauteile im montierten Zustand an einer ungewollten Bewegung. Durch die formschlüssige Anordnung der Magnetbaugruppen und Jochteile ergibt sich eine Eigensicherheit des Systems:
Im zusammengebauten Zustand sind alle Magnete in Richtung der auftretenden Kräfte gegen Bewegung gesichert. Die spezielle Jochgeometrie führt im Zusammenhang mit der Geometrie der Magnete dazu, dass alle Bauteile in ihren Endpositionen fixiert sind, vergleichbar etwa mit den Steinkeilen in einem Torbogen.

Aufgrund der erfindungsgemäßen Trommelform ergibt sich grundsätzlich und im Wesentlichen sogar zwangsläufig eine kompaktere Bauweise. Zudem ist diese Anordnung auch effizienter hinsichtlich des Materialaufwandes als andere Magnetanordnungen aus dem Stand der Technik mit vergleichbaren technischen Eckdaten (Luftspalt, Durchmesser des sphärischen Homogenitätsbereichs, nominale Flussdichte).

### Weitere Vorteile gegenüber dem Stand der Technik:

Die erfindungsgemäße Aufteilung in Deckel- und Trommelbaugruppe ermöglicht einen separaten Aufbau der einzelnen Baugruppen, wobei die Einzelmagnete bei der Montage quer zur Magnetkraft und damit kraftsparend an ihren Platz gebracht werden können. Die Radialmagnetsegmente werden auf der Innenseite des Jochs rutschend, also in z-Richtung gleitend an ihren Platz gebracht, die Axialmagnetsegmente werden auf der Rückseite des Polschuhs radial zum Zentrum des Polschuhs gleitet an ihren Platz gebracht.

Durch die erfindungsgemäßeTrommelform können die Segmente des Ringmagneten einfacher montiert werden, insbesondere ohne zusätzliche Stützjoche. Bei Magnetanordnungen nach dem Stand der Technik hingegen kontaktieren die Sekundärmagnete den eigentlichen Polschuh, also das ferromagnetische Material. Das ist bei der Erfindung nicht der Fall: Hier hat man konstruktionsbedingt immer einen kleinen Luftspalt dazwischen, weil Primär- und Sekundärmagnete an verschiedenen Baugruppen befestigt werden und gegeneinander beweglich sind (Deckelverstellung). Die dadurch gegebene Beweglichkeit der Deckelbaugruppen relativ zur Trommelbaugruppe kann für einen Justiermechanismus zur Einstellung der Feldhomogenität eingesetzt werden.

Der rotationssymmetrische Aufbau aufgrund der zylindrischen Geometrie passt sich optimal an die Form des Messvolumens an, so dass der Materialeinsatz durch die kürzere mittlere Eisenweglänge im Vergleich zu rechteckigen Anordnungen wesentlich effizienter ist.

Außerdem können durch die erfindungsgemäße Rotationssymmetrie die Jochbauteile äußerst kostengünstig auf einer Drehmaschine gefertigt werden. Schließlich ist auch eine einfache sequentielle Montage auf einer Drehplattform möglich.

### Bevorzugte Ausführungsformen und Weiterbildungen der Erfindung

Besonders bevorzugt ist eine Ausführungsform der erfindungsgemäßen Magnetanordnung, bei der die Jochelemente, die Magnetelemente sowie die Polschuhelemente jeweils Kreiszylindersymmetrie oder Zylindersymmetrie mit polygonalen Querschnittsflächen senkrecht zur z-Achse aufweisen. Diese Art der Symmetrie ermöglicht einen zyklischen Zusammenbau, d.h. eine stationäre "Bestückungsvorrichtung" und einen "Revolver" der den zu bestückenden Zylindersektor vor der Bestückungsvorrichtung positioniert und nach erfolgter Teilbestückung, durch Rotation auf den nächsten Zylindersektor weiterschwenkt. Beim Kreiszylinder ist das besonders leicht zu realisieren, weil die Trommel, dann auf Rollen gelagert werden kann und tatsächlich wie bei einem Trommelrevolver durch Rotation in Position gebracht wird.

Eine weitere Ausführungsform sieht vor, dass die Jochelemente mehrere, in axialer Richtung hintereinander angeordnete hohlzylindrische Trommeln umfassen. Eine solche Realisierung erlaubt es mehr Magnetmaterial entlang des Umfangs bei gleichem Poldurchmesser zu verbauen. Daraus lässt sich auch ein modulares Konzept zur Realisierung verschiedener Feldstärken unter Verwendung identischer Teilbaugruppen ableiten.

Besonders bevorzugt ist eine Ausführungsform, bei der die Radialmagnetringe und/oder die Axialmagnete segmentartig beziehungsweise keilförmig in radialer Richtung und/oder parallel zum Trommelumfang in azimutaler Richtung geteilt sind. Die Vorteile dieser Variante liegen in der guten Verfügbarkeit der verwendeten Rohmagnete begründet. Bei entsprechender Verfügbarkeit von gesinterten Bauteilen kann diese Stückelung bei anderen Ausführungsformen der Erfindung auch entfallen.

Vorteilhaft ist auch eine Ausführungsform, bei der vorgesehen ist, dass die hohlzylindrische(n) Trommel(n) der Jochelemente an ihrer (ihren) äußeren Mantelfläche(n) mindestens eine umlaufende Nut und/oder mindestens eine umlaufende Stufe und/oder an ihrer (ihren) Innenfläche(n) ein Stufenprofil aufweist (aufweisen). Derartige Ausprägungen der Erfindung können als Führungselemente bei der Montage oder als Schiene für verschiebbare Anbauteile dienen.

Eine bevorzugte Ausführungsform ist dadurch gekennzeichnet, dass die hohlzylindrische(n) Trommel(n) der Jochelemente mindestens einen, vorzugsweise mehrere paarweise bezüglich der z-Achse gegenüberliegend diametral angeordnete Durchbrüche beziehungsweise Zugangsöffnungen aufweist (aufweisen). Diese Öffnungen sind als Zugang zum Probenraum zwischen den Polen gedacht und dienen gleichzeitig als Wartungsöffnungen für Baugruppen wie Gradientenspulen, Shimsystem usw..

Eine weitere vorteilhafte Ausführungsform sieht vor, dass der erste Deckel und/oder der zweite Deckel der Jochelemente diskusförmig oder in axialer Richtung vom Messvolumen weg konisch zulaufend gestaltet ist. Konisch zulaufende Endbaugruppen, dienen der Verkürzung des mittleren Eisenweges für den magnetischen Fluss im Joch und ermöglichen eine Materialreduzierung und damit auch eine Gewichtsreduzierung.

Bevorzugt ist auch eine Ausführungsform, bei der der erste Deckel und/oder der zweite Deckel der Jochelemente einen in axialer Richtung zum Messvolumen hin ragenden Zentrierabschnitt längs der z-Achse aufweist.

Dieser Abschnitt kann als Vertiefung oder Erhebung ausgeführt werden und hilft bei der konzentrischen Ausrichtung von Deckel und Magnetring.

Bei einer weiteren bevorzugten Ausführungsform weist der erste Deckel und/oder der zweite Deckel der Jochelemente auf seiner zum Messvolumen hin ragenden Seite eine Ringnut, eine Stufe oder einen Absatz als Anschlag oder zum Halten der Axialmagnete auf. Da die Magnete beim Bestücken unter großem Kraftaufwand an die jeweilige Position gebracht werden, muss durch die Anschlagposition eine einheitliche Endposition sichergestellt sein bzw. ein Verschieben über die Sollposition hinaus verhindert werden.

Ganz besonders bevorzugt ist eine Ausführungsform, bei der die Polschuhelemente in axialer Richtung mehrteilig, insbesondere zweiteilig mit einer Polplatte und einer Polkappe oder dreiteilig mit einem zusätzlichen Polring ausgestaltet sind. Diverse Polschuhausprägungen, um eine guten Grundhomogenität zu erzielen. Bei Magnetsystemen, wo gepulste Gradienten zum Einsatz kommen, muss das dem Probenraum zugewandte Material (Polkappe) elektrisch nichtleitend sein. Derartige Materialien haben verminderte mechanische Belastbarkeit, deshalb kann z.B. die den Magneten zugewandte Basisplatte aus Eisen oder einen anderen tragfähigen, ferromagnetischen Material hergestellt werden.

Vorteilhaft ist auch eine Ausführungsform, bei der die Polschuhelemente mittels mindestens eines Befestigungselements aus nichtmagnetischem Material, insbesondere mittels eines Stifts, eines Bolzens oder einer Schraube an dem jeweils benachbarten ersten oder zweiten Deckel der Jochelemente fixiert sind. Die Verspannung des Deckels mit dem rückseitigen Polschuhelement ist zentraler Bestandteil des erfindungsgemäßen Sicherheitskonzepts. Die Polfläche ziehen sich magnetisch an, die Verbindung zum Deckel verhindert, dass Teile der zentralen Baugruppe sich in Richtung des Probevolumens bewegen können, wenn Klebeverbindungen versagen.

Weitere bevorzugte Ausführungsformen der erfindungsgemäßen Magnetanordnung zeichnen sich dadurch aus, dass an den Anstoßflächen zwischen den Deckeln und der Trommel ein oder mehrere Stellelemente angeordnet sind, etwa in Form von Stellschrauben, mit welchen der Anstoßwinkel und/ oder der Abstand zwischen den Deckeln und der Trommel, vorzugsweise im Bereich ≤ 1mm, justierbar und dadurch das Magnetfeld homogenisierbar ist. Die Deckel können damit parallel auf Abstand zu Trommel abgedrückt werden oder mit minimaler Verkippung. Damit sind unerwünschte Lineargradienten in gewissem Rahmen kompensierbar.

In den Rahmen der vorliegenden Erfindung fällt auch ein Verfahren zur Herstellung einer Magnetanordnung, umfassend folgende Schritte:
- Bereitstellen der Deckel und hohlzylindrischen Trommel(n) der Jochelemente
- Anordnen der Radialmagnetringe an der inneren Oberfläche der Trommel(n)
- Fixieren der Axialmagnete und der Polschuhe am ersten und zweiten Deckel der Jochelemente
- Verschieben der an den Deckeln fixierten Axialmagnete zusammen mit den Polschuhen in die jeweiligen Radialmagnetringe, die sich radial innerhalb der Trommel(n) befinden, sodass die Deckel auf der (den) hohlzylindrischen Trommel(n) der Jochelemente aufliegen und die Axialmagnete an einer definierten Position zumindest teilweise radial innerhalb der Radialmagnetringe angeordnet sind.

Bei der Montage bereits magnetisierter Permanentmagnete treten Anziehungs- und Abstoßungskräfte in der Größenordnung mehrerer Tonnen auf. Diese Kräfte müssen während der Bestückung abgestützt bzw. aufgefangen werden, um die Magnetelemente sicher an die vorgesehenen Positionen zu bringen. Das ist mit dem hier beschriebenen Montageverfahren besonders gut möglich.

Eine vorteilhafte Variante dieses Verfahrens zeichnet sich dadurch aus, dass zur Homogenisierung des Magnetfelds der erste und/oder zweite Deckel gegenüber der z-Achse verkippt und/oder in radialer Richtung verdreht wird.

Die Deckel können damit parallel auf Abstand zur Trommel abgedrückt werden oder mit minimaler Verkippung. Damit sind unerwünschte Lineargradienten in gewissem Rahmen kompensierbar.

Bevorzugt ist auch eine weitere Verfahrensvariante, bei welcher die Radialmagnetringe an durch Vorsprünge, Stufen oder Nuten an der Innenseite der hohlzylindrischen Trommel(n) vordefinierten Positionen angebracht werden. Da die Magnete beim Bestücken unter großem Kraftaufwand an die jeweilige Position gebracht werden, muss durch die Anschlagposition eine einheitliche Endposition sichergestellt werden bzw. ein Verschieben über die Sollposition hinaus verhindert werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig.1a: eine schematische räumliche Halbschnitt-Darstellung einer erfindungsgemäßen Magnetanordnung;
- Fig.1b: wie Fig.1a, jedoch ohne Polschuhe;
- Fig.1c: wie Fig.1b, jedoch ohne Deckel-Baugruppen;
- Fig. 2: Deckel-Baugruppen wie in Fig.1a;
- Fig.3a: Joch-Baugruppen mit Trommel und Deckeln, aber ohne Magnete;
- Fig.3b: wie Fig.3a, jedoch mit mehreren Trommel-Baugruppen;
- Fig.4a: halbaufgeschnittene Trommel-Baugruppe in zylindrischer Ausführung;
- Fig.4b: wie Fig.4a, jedoch mit konischer Randgestaltung;
- Fig.4c: wie Fig.4a, jedoch mit zwei umlaufenden Nuten;
- Fig.4d: wie Fig.4a, jedoch mit zwei umlaufenden Stufen;
- Fig.5a: vollständige Trommel-Baugruppe in zylindrischer Ausführung mit diametral angeordneten, rechteckigen Durchbrüchen;
- Fig.5b: wie Fig.5a, jedoch mit Durchbrüchen mit schlitzförmigen Aussparungen;
- Fig.5c: wie Fig.5a, jedoch mit H-förmigen Durchbrüchen;
- Fig.5d: wie Fig.5a, jedoch mit weiterer Ausformung der Durchbrüche;
- Fig.6a: segmentierte Magnet-Ringbaugruppe mit 8facher Teilung entlang des Umfangs;
- Fig.6b: Wie Fig.6a, jedoch mit 16facher Teilung entlang des Umfangs und 4facher axialer Teilung;
- Fig.7a: nicht-segmentierte Magnet-Ringbaugruppe mit durch Pfeile angedeuteter axialer Magnetisierung;
- Fig.7b: wie Fig.7a, jedoch mit 16facher Segmentierung entlang des Umfangs;
- Fig.7c: wie Fig.7b, jedoch mit durch Pfeile angedeuteter radialer Magnetisierung;
- Fig.8a: halbaufgeschnittenen Trommelbaugruppe mit Radialmagnet-Segmenten;
- Fig.8b: wie Fig.1a, jedoch mit durch Pfeile angedeuteten Magnetisierungen der Magnet-Segmente;
- Fig.9: wie Fig.8b, aber in frontaler Schnittansicht sowie mit zentralem Befestigungselement und angedeutetem Messvolumen;
- Fig.10a: halbaufgeschnittenes Polschuhelement in einteiliger Ausführung;
- Fig.10b: wie Fig.10a, jedoch in zweiteiliger Ausführung mit separatem Polring;
- Fig.10c: wie Fig.10b, jedoch in dreiteiliger Ausführung mit zusätzlicher separatem Polplatte; und
- Fig.11: wie Fig.1, jedoch mit Befestigungselementen sowie Stellelementen zur Justage der Deckelelemente.

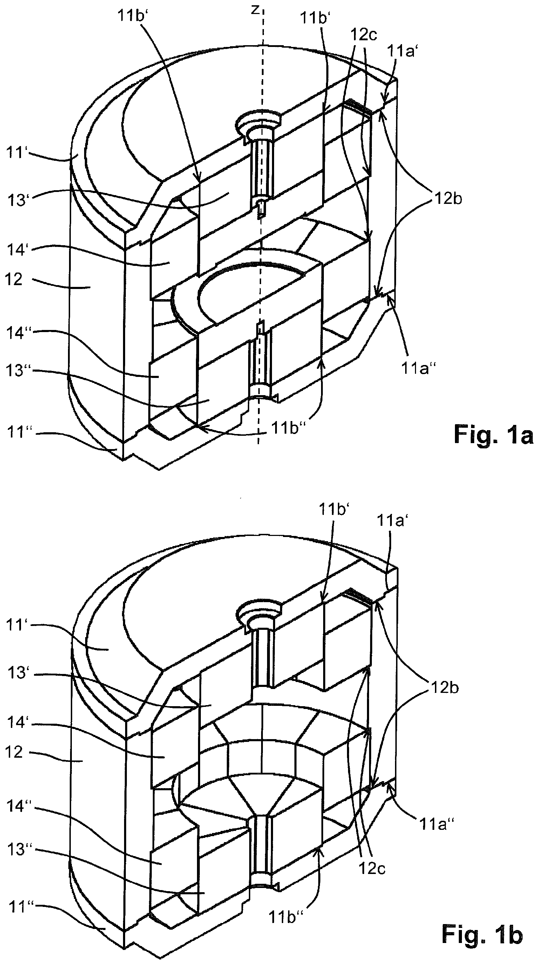

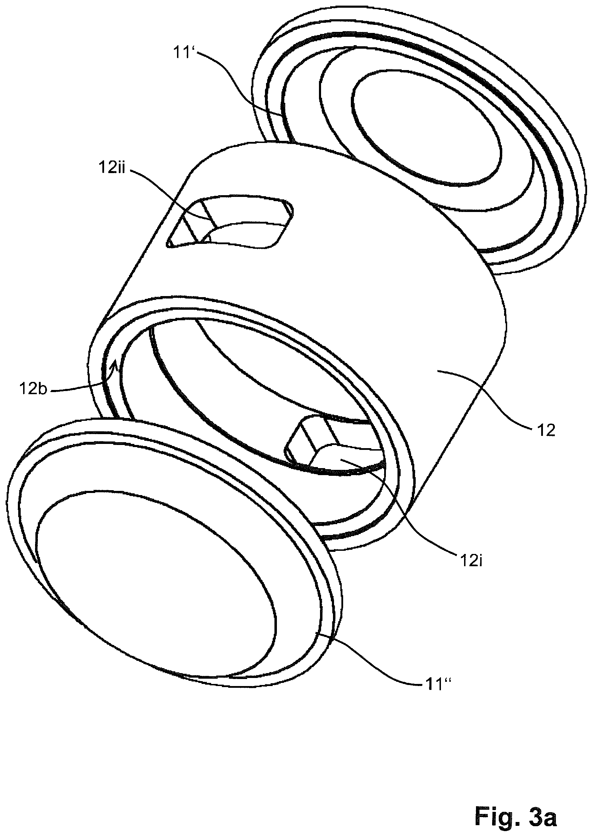

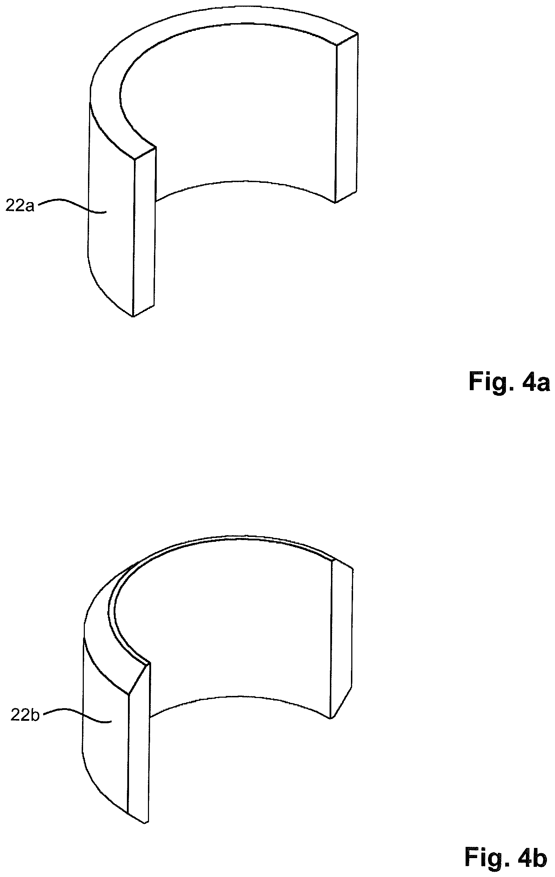

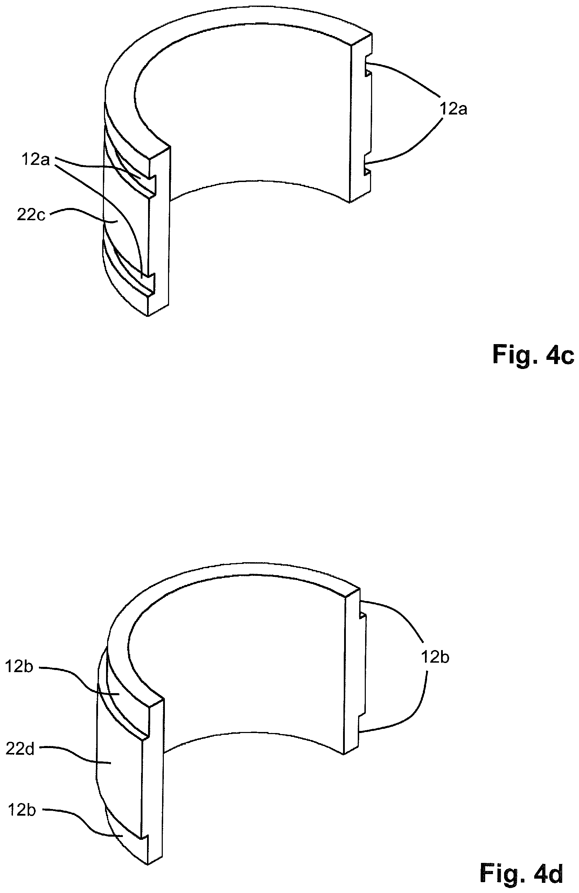

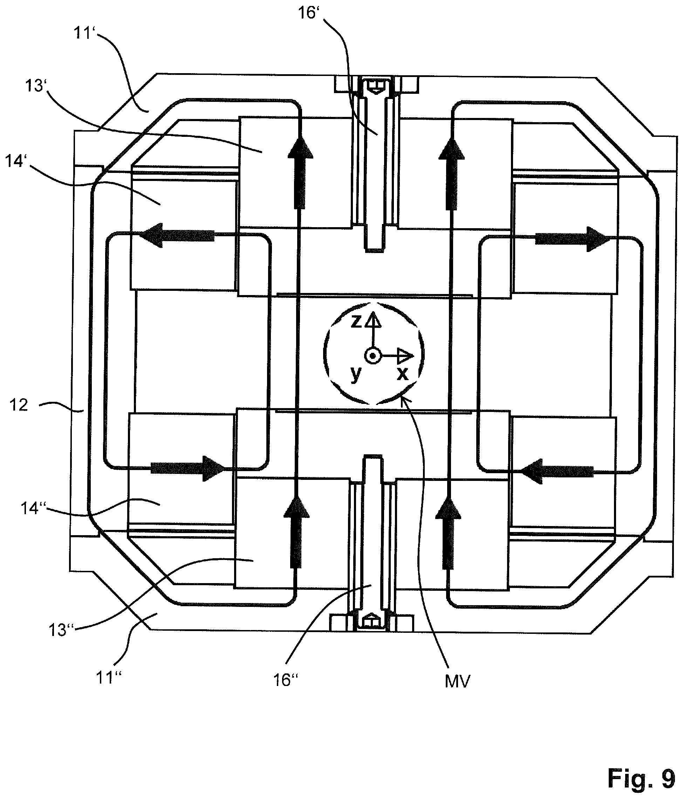

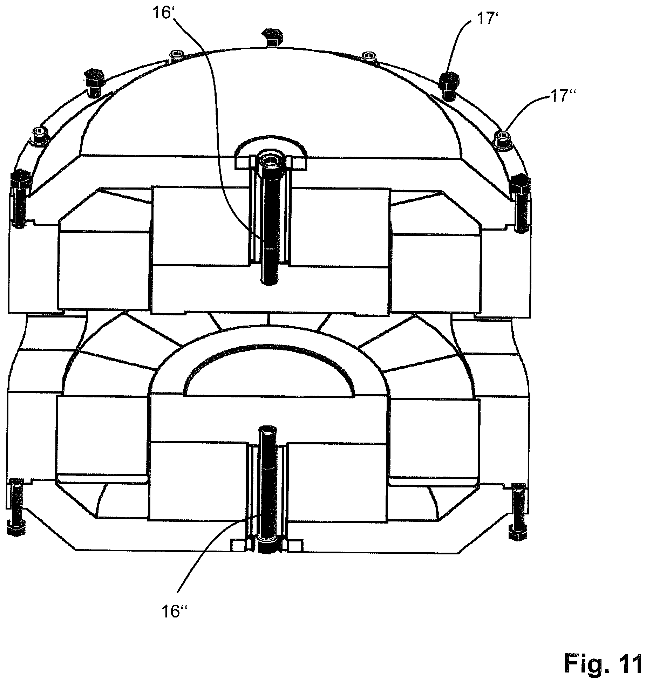

Die erfindungsgemäße Magnetanordnung, wie sie in den Figuren 1a und 11 jeweils schematisch im räumlichen Halbschnitt dargestellt ist, findet ihre Hauptanwendung als Bestandteil einer Magnetresonanz-Apparatur mit einem Permanentmagnetsystem zur Erzeugung eines homogenen Magnetfeldes in Richtung einer z-Achse in einem (in Fig.9 explizit gezeigten) **Messvolumen MV,** wobei das Permanentmagnetsystem bezüglich der z-Achse zylindersymmetrisch angeordnete Magnetelemente, Polschuhelemente und Jochelemente aus magnetischem Material aufweist. Erfindungsgemäß zeichnet sich die Magnetanordnung dadurch aus, dass die Jochelemente einen **ersten Deckel 11'** und einen **zweiten Deckel 11"** sowie mindestens eine in axialer Richtung bezüglich der z-Achse zwischen den Deckeln 11', 11" angeordnete **hohlzylindrische Trommel 12; 12',12",12'"; 22a; 22b; 22c; 22d** umfassen, für welche verschiedene vorteilhafte Ausführungsformen auch in den Figuren 3a bis 5d gezeigt sind.

Die Jochelemente umschließen das Messvolumen MV sowohl in axialer als auch in radialer Richtung. Die Magnetelemente umfassen mindestens ein Paar von zylindersymmetrischen **Axialmagneten 13', 13"** sowie ein Paar von zylindersymmetrischen **Radialmagnetringen 14', 14",** wobei die Axialmagnete 13', 13" die jeweils an die dem Messvolumen MV zugewandte Seite des ersten Deckels 11' beziehungsweise des zweiten Deckels 11" in axialer Richtung anschließend angeordnet sind, wobei die Axialmagnete 13', 13" radial innerhalb der Radialmagnetringe 14', 14" und jeweils in axialer Richtung weiter vom Messvolumen MV entfernt als die Radialmagnetringe 14', 14" angeordnet sind, und wobei der Außendurchmesser der Axialmagnete 13', 13" kleiner oder gleich dem Innendurchmesser der Radialmagnetringe 14', 14" ist.

Die Jochelemente, die Magnetelemente sowie die Polschuhelemente können jeweils Kreiszylindersymmetrie oder Zylindersymmetrie mit polygonalen Querschnittsflächen senkrecht zur z-Achse aufweisen.

Die Radialmagnetringe 14', 14" und /oder die Axialmagnete 13', 13" können segmentartig beziehungsweise keilförmig in radialer Richtung und/oder parallel zum Trommelumfang in azimutaler Richtung geteilt sein, wie in den Figuren 1a bis 1c, 6a bis 8b sowie 11 gut erkennbar ist.

Weiter ist den Figuren 1a bis 1c, 3a, 3b, 4c und 4d zu entnehmen, dass die hohlzylindrischen Trommeln 12; 12',12",12'"; 22c; 22d der Jochelemente an ihren äußeren Mantelflächen mindestens eine **umlaufende Nut 12a** und/oder mindestens eine **umlaufende Stufe 12b** und/oder an ihren Innenflächen ein **Stufenprofil 12c** aufweisen können.

Ebenfalls ist aus den Figuren 1a bis 2, 4c und 4d gut ersichtlich, dass der erste Deckel 11' und/oder der zweite Deckel 11" der Jochelemente auf seiner zum Messvolumen MV hin ragenden Seite eine Ringnut, eine **Stufe 11a'; 11a"** oder einen **Absatz 11b'; 11b"** als Anschlag oder zum Halten der Axialmagnete 13', 13" aufweisen kann.

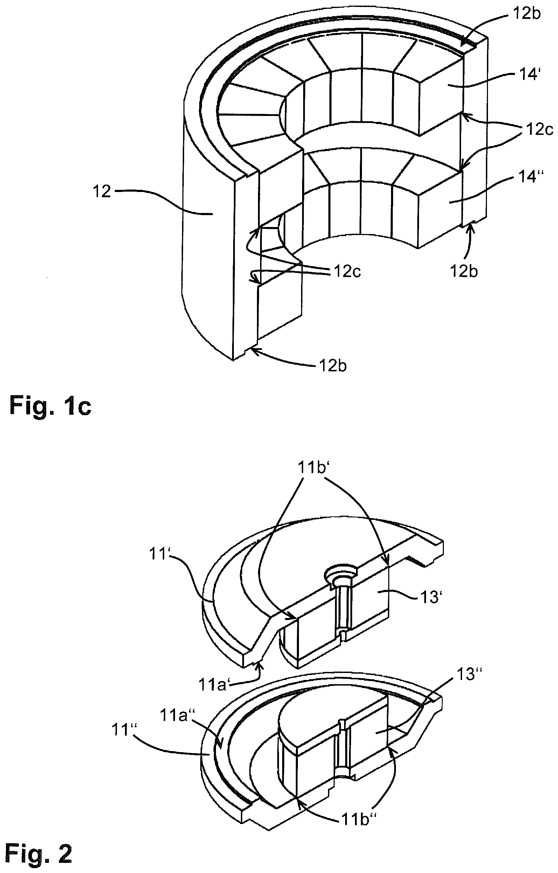

Wie etwa Fig.2 zeigt, kann der erste Deckel 11' und/oder der zweite Deckel 11" der Jochelemente diskusförmig oder in axialer Richtung vom Messvolumen MV weg konisch zulaufend gestaltet sein.

Bei in der Zeichnung nicht eigens dargestellten Ausführungsformen der Erfindung kann der erste Deckel 11' und/oder der zweite Deckel 11" der Jochelemente einen in axialer Richtung zum Messvolumen MV hin ragenden Zentrierabschnitt längs der z-Achse aufweisen.

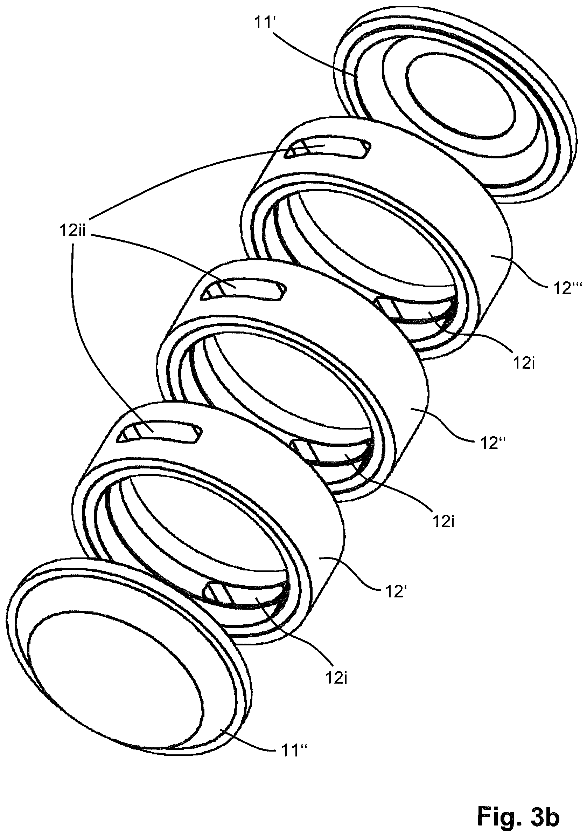

Die Jochelemente können -wie in Fig.3a dargestellt- eine einzige hohlzylindrische Trommeln 12 aufweisen, aber auch -wie in Fig.3b dargestelltmehrere, in axialer Richtung hintereinander angeordnete hohlzylindrische Trommeln 12',12",12'" umfassen.

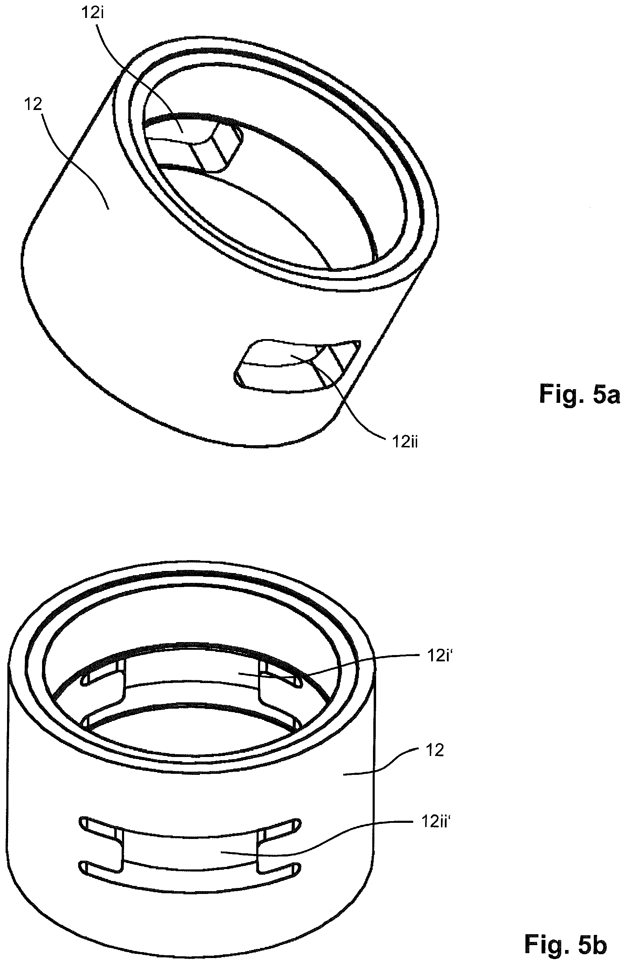

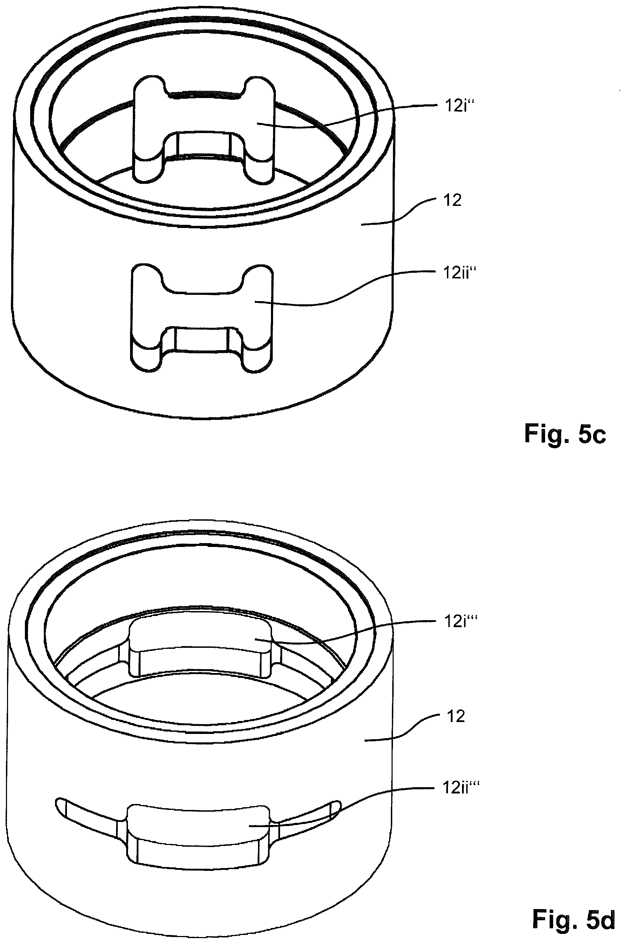

Aus den Figuren 3a, 3b und 5a bis 5d erkennt man Ausführungsformen der Erfindung, bei denen die hohlzylindrischen Trommeln 12; 12',12",12'" der Jochelemente jeweils paarweise bezüglich der z-Achse gegenüberliegend diametral angeordnete **Durchbrüche 12i;12ii; 12i';12ii'; 12i";12ii"; 12i"';12ii'"** beziehungsweise Zugangsöffnungen aufweisen, welche unterschiedliche geometrische Ausbildungen aufweisen können.

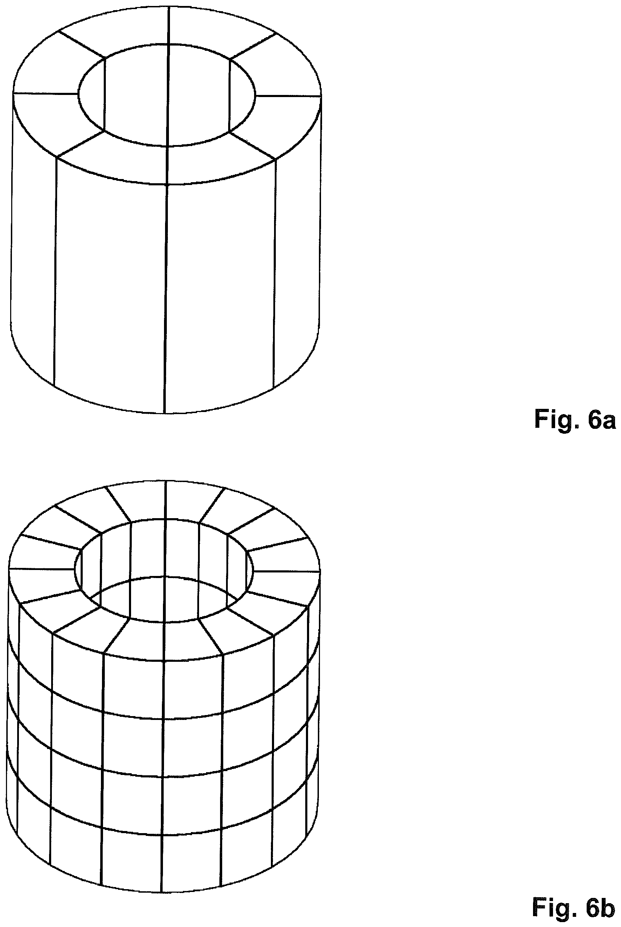

Die Figuren 6a und 6b verdeutlichen die vielfältigen Möglichkeiten einer segmentierten Gestaltung der bei einer erfindungsgemäßen Magnetanordnung einsetzbaren Magnetelemente. So zeigt Fig.6a eine segmentierte Magnet-Ringbaugruppe mit 8facher Teilung entlang des Umfangs, Fig.6b eine Baugruppe mit 16facher Teilung entlang des Umfangs und 4facher axialer Teilung.

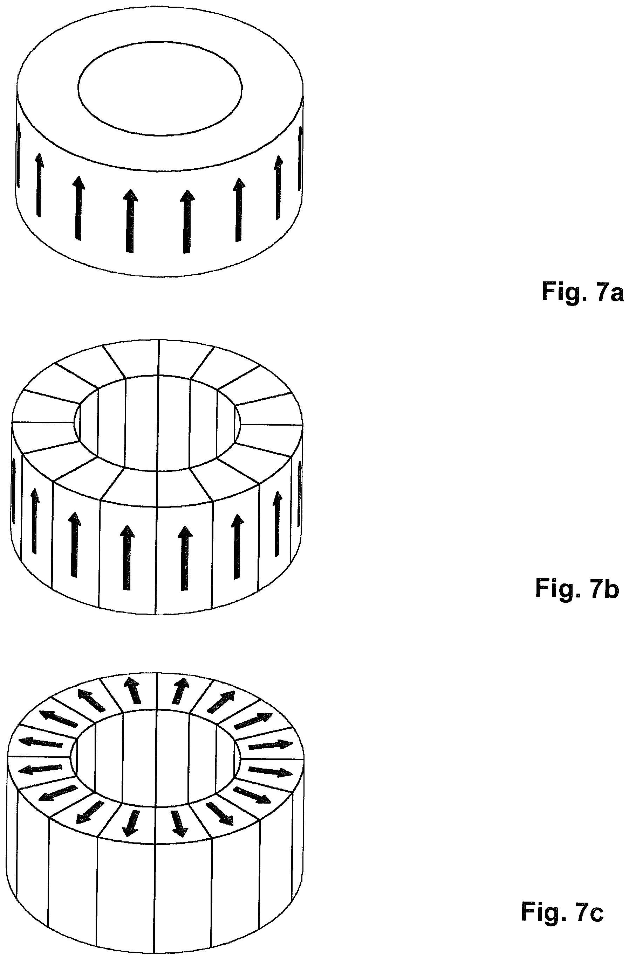

In den Figuren 7a bis 8b sind jeweils Magnet-Ringbaugruppe mit durch Pfeile angedeuteter Magnetisierung dargestellt, und zwar:
in Fig.7a eine nicht-segmentierte Magnet-Ringbaugruppe mit axialer Magnetisierung,
in Fig.7b eine Baugruppe mit 16facher Segmentierung entlang des Umfangs und axialer Magnetisierung,
in Fig.7c eine Baugruppe mit 16facher Segmentierung entlang des Umfangs und radialer Magnetisierung,

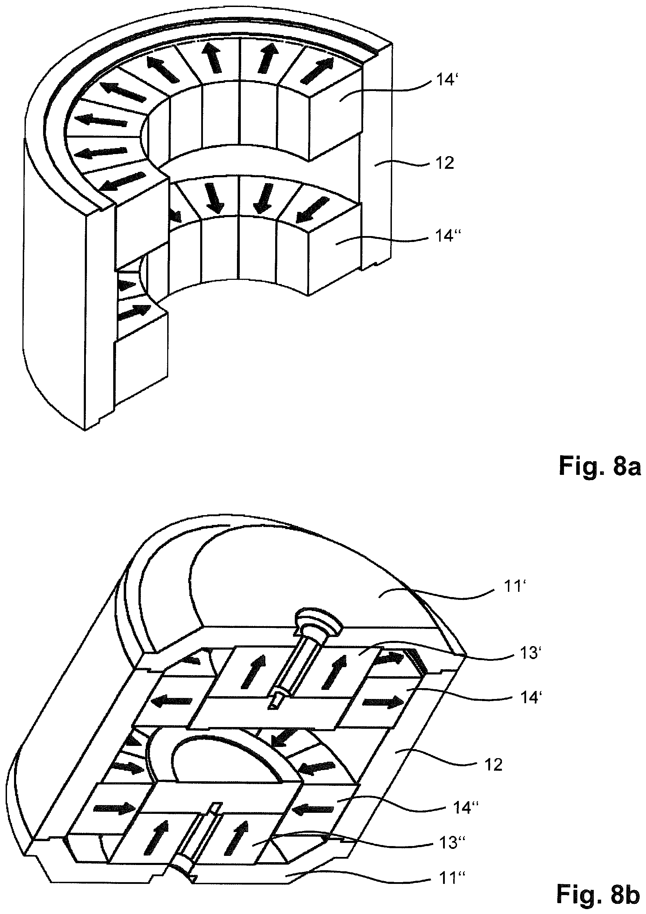

in Fig.8a eine Trommelbaugruppe mit Radialmagnet-Segmenten; und
in Fig.8b Magnet-Segmente sowohl mit axialer als auch mit radialer Magnetisierung.
Fig. 9 zeigt darüber hinaus in frontaler Schnittansicht eine erfindungsgemäße Anordnung mit angedeutetem Messvolumen sowie mit schematisch zu magnetischen Flusslinien fortgesetzten Magnetisierungspfeilen. Man erkennt außerdem, dass die Polschuhelemente mittels eines **zentralen Befestigungselements 16', 16"** aus nichtmagnetischem Material, insbesondere mittels eines Stifts, eines Bolzens oder einer Schraube an dem jeweils benachbarten ersten Deckel 11' beziehungsweise zweiten Deckel 11" der Jochelemente fixiert sind.

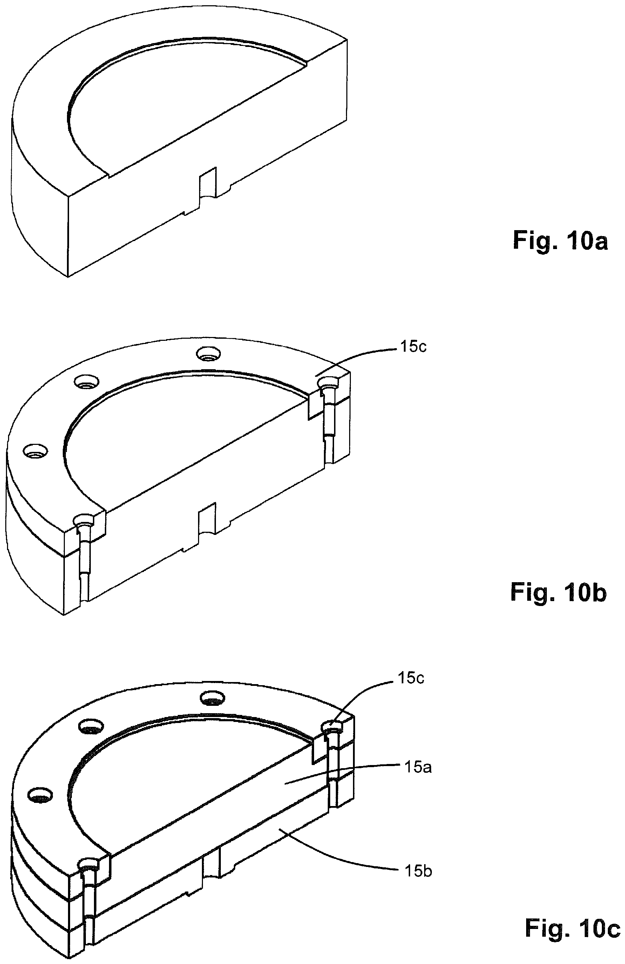

Fig.10a zeigt ein halbaufgeschnittenes Polschuhelement in einteiliger Ausführung.
Fig.10b zeigt ein (ebenfalls halbaufgeschnittenes) Polschuhelement in zweiteiliger Ausführung mit separatem **Polring 15c.**
Fig. 10c zeigt eine dreiteilige Ausführung eines Polschuhelements mit einer **Polplatte 15a,** einer **Polkappe 15b** und einem zusätzlichen Polring 15c.
Fig.11 schließlich stellt eine erfindungsgemäße Magnetanordnung dar, wie sie auch schon in Fig.1 gezeigt ist. Darüber hinaus enthält die Magnetanordnung aber auch Befestigungselemente sowie Stellelemente zur Justage der Deckelelemente. Insbesondere sind an den Anstoßflächen zwischen den Deckeln 11' bzw. 11" und der Trommel 12 bzw. 12" mehrere **Stellelemente 17', 17"** in Form von Stellschrauben angeordnet, mit welchen der Anstoßwinkel und/ oder der Abstand zwischen den Deckeln 11' bzw. 11" und der Trommel 12 bzw. 12", vorzugsweise im Bereich ≤ 1mm, justierbar und dadurch das Magnetfeld homogenisierbar ist. Dabei können zum einen Stellschrauben 17' eingesetzt werden, die etwa mit einem Sechskantkopf ausgestattet sein können und mit denen die Deckel 11' bzw. 11" durch Eindrehen dieser Stellschrauben 17' in ein entsprechendes Gewinde im jeweiligen Deckel 11' bzw. 11" angehoben werden können. Mittels weiterer Stellschrauben 17"die etwa mit einem Imbuskopf ausgestattet sein können, werden die Deckel 11' bzw. 11" gegen die jeweilige Trommel 12 bzw. 12" verspannt.

Zur Herstellung einer erfindungsgemäßen Magnetanordnung kann ein Verfahren mit folgenden Schritten angewandt werden:
- Bereitstellen der Deckel 11', 11" und hohlzylindrischen Trommel(n) 12; 12',12",12'"; 22a; 22b; 22c; 22d der Jochelemente
- Anordnen der Radialmagnetringe 14', 14" an der inneren Oberfläche der Trommel(n) 12; 12',12",12"'; 22a; 22b; 22c; 22d
- Fixieren der Axialmagnete 13', 13" und der Polschuhe am ersten Deckel 11' und am zweiten Deckel 11" der Jochelemente
- Verschieben der an den Deckeln 11', 11" fixierten Axialmagnete 13', 13" zusammen mit den Polschuhen in die jeweiligen Radialmagnetringe 14', 14", die sich radial innerhalb der Trommel(n) 12; 12',12",12'"; 22a; 22b; 22c; 22d befinden, sodass die Deckel 11', 11" auf der (den) hohlzylindrischen Trommel(n) 12; 12',12",12'"; 22a; 22b; 22c; 22d der Jochelemente aufliegen und die Axialmagnete 13', 13" an einer definierten Position zumindest teilweise radial innerhalb der Radialmagnetringe 14', 14" angeordnet sind.
Magnetfelds der erste Deckel 11' und/oder der zweite Deckel 11" gegenüber der z-Achse verkippt und/oder in radialer Richtung verdreht wird.

Zur Homogenisierung des Magnetfelds wird der erste Deckel 11' und/oder der zweite Deckel 11" gegenüber der z-Achse verkippt und/oder in radialer Richtung verdreht.

Die Radialmagnetringe 14', 14" werden an durch Vorsprünge, Stufen 12b oder Nuten 12a an der Innenseite der hohlzylindrischen Trommel(n) 12; 12',12",12'"; 22a; 22b; 22c; 22d vordefinierten Positionen angebracht.

### Bezugszeichenliste:

- 11': erster Deckel
- 11": zweiter Deckel
- 11a'; 11a": Ringnut
- 11b';: Absatz
- 12, 12', 12": hohlzylindrische Trommel(n)
- 12a: umlaufende Nut
- 12b: umlaufende Stufe
- 12c: Stufenprofil
- 12i; 12ii: Durchbruch
- 13': erster zylindersymmetrischer Axialmagnet
- 13": zweiter zylindersymmetrischer Axialmagnet
- 14', 14": zylindersymmetrische Radialmagnetringe
- 15a: Polkappe
- 15b: Polplatte
- 15c: Polring
- 16', 16": Befestigungselemente
- 17', 17": Stellelemente

- MV: Messvolumen
- z: z-Achse

## Patentansprüche

1. Magnetanordnung für eine Magnetresonanz-Apparatur, mit einem Permanentmagnetsystem zur Erzeugung eines homogenen Magnetfeldes in Richtung einer z-Achse in einem Messvolumen (MV), wobei das Permanentmagnetsystem bezüglich der z-Achse zylindersymmetrisch angeordnete Magnetelemente, Polschuhelemente und Jochelemente aus magnetischem Material aufweist,
**dadurch gekennzeichnet,**
**dass** die Jochelemente einen ersten Deckel (11') und einen zweiten Deckel (11") sowie mindestens eine in axialer Richtung bezüglich der z-Achse zwischen den Deckeln (11', 11") angeordnete hohlzylindrische Trommel (12; 12',12",12'"; 22a; 22b; 22c; 22d) umfassen, wobei die Jochelemente das Messvolumen (MV) sowohl in axialer als auch in radialer Richtung umschließen,
und **dass** die Magnetelemente mindestens ein Paar von zylindersymmetrischen Axialmagneten (13', 13") sowie ein Paar von zylindersymmetrischen Radialmagnetringen (14', 14") umfassen, wobei die Axialmagnete (13', 13") die jeweils an die dem Messvolumen (MV) zugewandte Seite des ersten Deckels (11') beziehungsweise des zweiten Deckels (11") in axialer Richtung anschließend angeordnet sind, wobei die Axialmagnete (13', 13") radial innerhalb der Radialmagnetringe (14', 14") und jeweils in axialer Richtung weiter vom Messvolumen (MV) entfernt als die Radialmagnetringe (14', 14") angeordnet sind, und wobei gilt: Außendurchmesser der Axialmagnete (13', 13") ≤ Innendurchmesser der Radialmagnetringe (14', 14").

2. Magnetanordnung nach Anspruch 1, **dadurch gekennzeichnet, dass** die Jochelemente, die Magnetelemente sowie die Polschuhelemente jeweils Kreiszylindersymmetrie oder Zylindersymmetrie mit polygonalen Querschnittsflächen senkrecht zur z-Achse aufweisen.

3. Magnetanordnung nach einem der vorhergehenden Ansprüche, **dadurch gekennzeichnet, dass** die Jochelemente mehrere, in axialer Richtung hintereinander angeordnete hohlzylindrische Trommeln (12',12",12"'; 22a; 22b; 22c; 22d) umfassen.

4. Magnetanordnung nach einem der vorhergehenden Ansprüche, **dadurch gekennzeichnet, dass** die Radialmagnetringe (14', 14") und /oder die Axialmagnete (13', 13") segmentartig beziehungsweise keilförmig in radialer Richtung und/oder parallel zum Trommelumfang in azimutaler Richtung geteilt sind.

5. Magnetanordnung nach einem der vorhergehenden Ansprüche, **dadurch gekennzeichnet, dass** die hohlzylindrische(n) Trommel(n) (12; 12',12",12"'; 22a; 22b; 22c; 22d) der Jochelemente an ihrer (ihren) äußeren Mantelfläche(n) mindestens eine umlaufende Nut (12a) und/oder mindestens eine umlaufende Stufe (12b) und/oder an ihrer (ihren) Innenfläche(n) ein Stufenprofil (12c) aufweist (aufweisen).

6. Magnetanordnung nach einem der vorhergehenden Ansprüche, **dadurch gekennzeichnet, dass** die hohlzylindrische(n) Trommel(n) (12; 12',12",12'"; 22a; 22b; 22c; 22d) der Jochelemente mindestens einen, vorzugsweise mehrere paarweise bezüglich der z-Achse gegenüberliegend diametral angeordnete Durchbrüche (12i;12ii; 12i';12ii'; 12i";12ii"; 12i'";12ii'") beziehungsweise Zugangsöffnungen aufweist (aufweisen).

7. Magnetanordnung nach einem der vorhergehenden Ansprüche, **dadurch gekennzeichnet, dass** der erste Deckel (11') und/oder der zweite Deckel (11") der Jochelemente diskusförmig oder in axialer Richtung vom Messvolumen (MV) weg konisch zulaufend gestaltet ist.

8. Magnetanordnung nach einem der vorhergehenden Ansprüche, **dadurch gekennzeichnet, dass** der erste Deckel (11') und/oder der zweite Deckel (11") der Jochelemente einen in axialer Richtung zum Messvolumen (MV) hin ragenden Zentrierabschnitt längs der z-Achse aufweist.

9. Magnetanordnung nach einem der vorhergehenden Ansprüche, **dadurch gekennzeichnet, dass** der erste Deckel (11') und/oder der zweite Deckel (11") der Jochelemente auf seiner zum Messvolumen (MV) hin ragenden Seite eine Ringnut (11a'; 11a"), eine Stufe oder einen Absatz (11b'; 11b") als Anschlag oder zum Halten der Axialmagnete (13', 13") aufweist.

10. Magnetanordnung nach einem der vorhergehenden Ansprüche, **dadurch gekennzeichnet, dass** die Polschuhelemente in axialer Richtung mehrteilig, insbesondere zweiteilig mit einer Polplatte (15a) und einer Polkappe (15b) oder dreiteilig mit einem zusätzlichen Polring (15c) ausgestaltet sind.

11. Magnetanordnung nach einem der vorhergehenden Ansprüche, **dadurch gekennzeichnet, dass** die Polschuhelemente mittels mindestens eines Befestigungselements (16', 16") aus nichtmagnetischem Material, insbesondere mittels eines Stifts, eines Bolzens oder einer Schraube an dem jeweils benachbarten ersten Deckel (11') oder zweiten Deckel (11") der Jochelemente fixiert sind.

12. Magnetanordnung nach einem der vorhergehenden Ansprüche, **dadurch gekennzeichnet, dass** an den Anstoßflächen zwischen den Deckeln (11' bzw. 11") und der Trommel (12 bzw. 12") ein oder mehrere Stellelemente (17', 17") angeordnet sind, etwa in Form von Stellschrauben, mit welchen der Anstoßwinkel und/ oder der Abstand zwischen den Deckeln (11' bzw. 11") und der Trommel (12 bzw. 12"), vorzugsweise im Bereich ≤ 5mm, justierbar und dadurch das Magnetfeld homogenisierbar ist.

13. Verfahren zur Herstellung einer Magnetanordnung nach einem der vorhergehenden Ansprüche, umfassend folgende Schritte:
- Bereitstellen der Deckel (11', 11") und hohlzylindrischen Trommel(n) (12; 12',12",12"'; 22a; 22b; 22c; 22d) der Jochelemente
- Anordnen der Radialmagnetringe (14', 14") an der inneren Oberfläche der Trommel(n) (12; 12',12",12"'; 22a; 22b; 22c; 22d)
- Fixieren der Axialmagnete (13', 13") und der Polschuhe am ersten Deckel (11') und am zweiten Deckel (11") der Jochelemente
- Verschieben der an den Deckeln (11', 11") fixierten Axialmagnete (13', 13") zusammen mit den Polschuhen in die jeweiligen Radialmagnetringe (14', 14"), die sich radial innerhalb der Trommel(n) (12; 12',12",12'"; 22a; 22b; 22c; 22d) befinden, sodass die Deckel (11', 11") auf der (den) hohlzylindrischen Trommel(n) (12; 12',12",12"'; 22a; 22b; 22c; 22d) der Jochelemente aufliegen und die Axialmagnete (13', 13") an einer definierten Position zumindest teilweise radial innerhalb der Radialmagnetringe (14', 14") angeordnet sind.

14. Verfahren nach Anspruch 13, wobei zur Homogenisierung des Magnetfelds der erste Deckel (11') und/oder der zweite Deckel (11") gegenüber der z-Achse verkippt und/oder um die z-Achse verdreht wird.

15. Verfahren nach Anspruch 13 oder 14, wobei die Radialmagnetringe (14', 14") an durch Vorsprünge oder Stufen (12c) vordefinierten Positionen an der Innenseite der hohlzylindrischen Trommel(n) (12; 12',12",12"'; 22a; 22b; 22c; 22d) angebracht werden.

## Claims

1. Magnet arrangement for a magnetic resonance apparatus with a permanent magnet system for generating a homogeneous magnetic field in the direction of a z axis in a measuring volume (MV), the permanent magnet system having magnet elements, pole shoe elements and yoke elements of magnetic material arranged cylinder-symmetrically with respect to the z axis,
**characterized in that** the yoke elements comprise a first lid (11') and a second lid (11") and also at least one hollow cylindrical drum (12; 12', 12", 12'"; 22a; 22b; 22c; 22d) arranged axially between the lids (11', 11") with respect to the z axis, wherein the yoke elements enclose the measuring volume (MV) both in the axial direction and in the radial direction,
and **in that** the magnet elements each comprise at least one pair of cylinder-symmetrical axial magnets (13', 13") and one pair of cylinder-symmetrical radial magnet rings (14', 14"), wherein the axial magnets (13', 13") are each arranged axially adjoining the side of the first lid (11') or of the second lid (11") facing towards the measuring volume (MV), wherein the axial magnets (13', 13") are arranged radially within the radial magnet rings (14', 14") and in each case axially further away from the measuring volume (MV) than the radial magnet rings (14', 14"), and wherein the following applies: external diameter of the axial magnets (13', 13") ≤ internal diameter of the radial magnet rings (14', 14").

2. Magnet arrangement according to Claim 1, **characterized in that** the yoke elements, the magnet elements and the pole shoe elements each have circular cylinder symmetry or cylinder symmetry with polygonal cross-sectional surfaces perpendicular to the z axis.

3. Magnet arrangement according to one of the preceding claims, **characterized in that** the yoke elements comprise a plurality of hollow cylindrical drums (12', 12", 12"'; 22a; 22b; 22c; 22d) arranged one after another in the axial direction.

4. Magnet arrangement according to one of the preceding claims, **characterized in that** the radial magnet rings (14', 14") and/or the axial magnets (13', 13") are divided segment-like or wedge-like in the radial direction and/or parallel to the drum circumference in the azimuthal direction.

5. Magnet arrangement according to one of the preceding claims, **characterized in that** the hollow cylindrical drum(s) (12; 12', 12", 12"'; 22a; 22b; 22c; 22d) of the yoke elements has (have), on its (their) outer jacket surface(s), at least one circumferential groove (12a) and/or at least one circumferential step (12b) and/or, on its (their) inner surface(s), a stepped profile (12c).

6. Magnet arrangement according to one of the preceding claims, **characterized in that** the hollow cylindrical drum(s) (12; 12', 12", 12"'; 22a; 22b; 22c; 22d) of the yoke elements has (have) at least one aperture or preferably several apertures (12i; 12ii; 12i'; 12ii'; 12i"; 12ii"; 12i'"; 12ii"') or access openings arranged diametrically opposite one another with respect to the z axis preferably in pairs.

7. Magnet arrangement according to one of the preceding claims, **characterized in that** the first lid (11') and/or the second lid (11") of the yoke elements is discus-shaped or tapers conically in the axial direction away from the measuring volume (MV).

8. Magnet arrangement according to one of the preceding claims, **characterized in that** the first lid (11') and/or the second lid (11") of the yoke elements has, along the z axis, a centring portion protruding in the axial direction towards the measuring volume (MV).

9. Magnet arrangement according to one of the preceding claims, **characterized in that** the first lid (11') and/or the second lid (11") of the yoke elements has, on its side protruding towards the measuring volume (MV), an annular groove (11a'; 11a"), a step or a shoulder (11b'; 11b") as a limit stop or for holding the axial magnets (13', 13").

10. Magnet arrangement according to one of the preceding claims, **characterized in that** the pole shoe elements are configured in the axial direction in multiple parts, in particular in two parts with a pole plate (15a) and a pole cap (15b), or in three parts with an additional pole ring (15c).

11. Magnet arrangement according to one of the preceding claims, **characterized in that** the pole shoe elements are fixed on the respectively adjacent first lid (11') or second lid (11") of the yoke elements by means of at least one fastening element (16', 16") of non-magnetic material, in particular by means of a pin, a bolt or a screw.

12. Magnet arrangement according to one of the preceding claims, **characterized in that**, on the abutment faces between the lids (11', 11") and the drum (12, 12"), respectively, one or more adjusting elements (17', 17") are arranged, for example in the form of adjusting screws, with which the abutment angle and/or the distance between the lids (11', 11") and the drum (12, 12"), preferably in the range ≤ 5 mm, is adjustable and the magnetic field can thereby be homogenized.

13. Method for producing a magnet arrangement according to one of the preceding claims, comprising the following steps:
- making available the lids (11', 11") and hollow cylindrical drum(s) (12; 12',12",12"'; 22a; 22b; 22c; 22d) of the yoke elements
- arranging the radial magnet rings (14', 14") on the inner surface of the drum(s) (12; 12',12",12'"; 22a; 22b; 22c; 22d)
- fixing the axial magnets (13', 13") and the pole shoes on the first lid (11') and on the second lid (11") of the yoke elements
- moving the axial magnets (13', 13"), fixed on the lids (11', 11"), together with the pole shoes into the respective radial magnet rings (14', 14"), which are located radially within the drum(s) (12; 12',12",12"'; 22a; 22b; 22c; 22d), such that the lids (11', 11") bear on the hollow cylindrical drum(s) (12; 12',12",12'"; 22a; 22b; 22c; 22d) of the yoke elements, and the axial magnets (13', 13") are arranged at a defined position at least partially radially within the radial magnet rings (14', 14").

14. Method according to Claim 13, wherein, in order to homogenize the magnetic field, the first lid (11') and/or the second lid (11") is tilted relative to the z axis and/or rotated about the z axis.

15. Method according to Claim 13 or 14, wherein the radial magnet rings (14', 14") are mounted on the inner face of the hollow cylindrical drum(s) (12; 12',12",12"'; 22a; 22b; 22c; 22d) at positions predefined by projections or steps (12c).

## Revendications

1. Agencement d'aimants destiné à un appareillage à résonance magnétique, doté d'un système d'aimants permanents pour la création d'un champ magnétique homogène dans la direction d'un axe z dans un volume à mesurer (MV), le système d'aimants permanents comportant des éléments magnétiques, des éléments à pièces polaires et des éléments à étriers en matière magnétique placés en symétrie cylindrique par rapport à l'axe z,
**caractérisé en ce que**
les éléments à étriers comprennent un premier couvercle (11') et un deuxième couvercle (11"), ainsi qu'au moins un tambour cylindrique creux (12 ; 12', 12'', 12'" ; 22a ; 22b ; 22c ; 22d) placé entre les couvercles (11', 11''), dans la direction axiale, par rapport à l'axe z, les éléments à étriers entourant le volume à mesurer (MV) aussi bien en direction axiale que radiale,
et **en ce que** les éléments magnétiques comprennent au moins une paire d'aimants axiaux (13', 13'') cylindrosymétriques, ainsi qu'une paire d'anneaux aimantés radiaux (14', 14'') cylindrosymétriques, les aimants axiaux (13', 13'') étant placés en se raccordant dans la direction axiale sur le côté du premier couvercle (11'), respectivement du deuxième couvercle (11'') qui fait chaque fois face au volume à mesurer (MV), les aimants axiaux (13', 13'') étant placés de manière radiale à l'intérieur des anneaux aimantés radiaux (14', 14'') et chaque fois en direction axiale en étant plus éloignés du volume à mesurer (MV) que les anneaux aimantés radiaux (14', 14''), sachant qu'on applique :
diamètre extérieur des aimants axiaux (13', 13'') ≤ diamètre intérieur des anneaux aimantés radiaux (14', 14").

2. Agencement d'aimants selon la revendication 1, **caractérisé en ce que** les éléments à étriers, les éléments magnétiques, ainsi que les éléments à pièces polaires présentent chacun une symétrie cylindrique circulaire ou une symétrie cylindrique avec des surfaces de section transversale polygonales, à la perpendiculaire de l'axe z.

3. Agencement d'aimants selon l'une quelconque des revendications précédentes, **caractérisé en ce que** les éléments à étriers comprennent plusieurs tambours cylindriques creux (12', 12", 12"' ; 22a ; 22b ; 22c ; 22d), placés les uns derrière les autres, dans la direction axiale.

4. Agencement d'aimants selon l'une quelconque des revendications précédentes, **caractérisé en ce que** les anneaux aimantés radiaux (14', 14'') et/ou les aimants axiaux (13', 13") sont divisés en segments, respectivement de manière cunéiforme dans la direction radiale et/ou à la parallèle de la circonférence du tambour, dans la direction azimutale.

5. Agencement d'aimants selon l'une quelconque des revendications précédentes, **caractérisé en ce que** sur sa (/leur) surface(s) d'enveloppe extérieures, le (s) tambour(s) cylindrique(s) creux (12 ; 12', 12'', 12"' ; 22a ; 22b ; 22c ; 22d) des éléments à étriers comporte(nt) au moins une rainure périphérique (12a) et/ou au moins un échelon périphérique (12b) et/ou sur sa (/leur) surface(s) intérieure(s), comporte(nt) un profilé échelonné (12c).

6. Agencement d'aimants selon l'une quelconque des revendications précédentes, **caractérisé en ce que** le(s) tambour(s) cylindrique(s) creux (12 ; 12', 12", 12"' ; 22a ; 22b ; 22c ; 22d) des éléments à étriers comporte(nt) au moins un, de préférence plusieurs ajour(s) (12i ; 12ii ; 12i' ; 12ii' ; 12i" ; 12ii" ; 12i"' ; 12ii'''), respectivement orifices d'accès placés par paires, diamétralement en vis-à-vis par rapport à l'axe z.

7. Agencement d'aimants selon l'une quelconque des revendications précédentes, **caractérisé en ce que** le premier couvercle (11') et/ou le deuxième couvercle (11'') des éléments à étriers est conçu en forme de disque ou est conçu en pointe conique en direction axiale, en s'éloignant du volume à mesurer (MV).

8. Agencement d'aimants selon l'une quelconque des revendications précédentes, **caractérisé en ce que** le premier couvercle (11') et/ou le deuxième couvercle (11") des éléments à étriers comporte le long de l'axe z une partie de centrage saillant en direction axiale vers le volume à mesurer (MV).

9. Agencement d'aimants selon l'une quelconque des revendications précédentes, **caractérisé en ce que** sur son côté saillant vers le volume à mesurer (MV), le premier couvercle (11') et/ou le deuxième couvercle (11") des éléments à étriers comportent une rainure annulaire (11a' ; 11a"), un échelon ou un talon (11b' ; 11b") servant de butée ou pour maintenir les aimants axiaux (13', 13").

10. Agencement d'aimants selon l'une quelconque des revendications précédentes, **caractérisé en ce que** dans la direction axiale, les éléments à pièces polaires sont conçus en plusieurs parties, notamment en deux parties, avec une plaque polaire (15a) et une calotte polaire (15b) ou en trois parties, avec un anneau polaire (15c) supplémentaire.

11. Agencement d'aimants selon l'une quelconque des revendications précédentes, **caractérisé en ce que** les éléments à pièces polaires sont fixés au moyen d'au moins un élément de fixation (16', 16") en matière non magnétique, notamment au moyen d'une goupille, d'un boulon ou d'une vis sur le premier couvercle (11') ou deuxième couvercle (11") chaque fois voisin des éléments à étriers.

12. Agencement d'aimants selon l'une quelconque des revendications précédentes, **caractérisé en ce que** sur les surfaces d'aboutement entre les couvercles (11' ou 11") et le tambour (12 ou 12") sont placés un ou plusieurs éléments de réglage (17', 17"), par exemple sous la forme de vis de réglage, avec lesquels l'angle d'aboutement et/ou l'écart entre les couvercles (11' ou 11") et le tambour (12 ou 12") est ajustable, de préférence dans l'ordre ≤ 5 mm, et de ce fait, le champ magnétique est homogénéisable.

13. Procédé, destiné à fabriquer un agencement d'aimants selon l'une quelconque des revendications précédentes, comprenant les étapes suivantes :
- de la mise à disposition des couvercles (11', 11") et du (/des) tambour(s) cylindrique(s) creux (12 ; 12', 12", 12'" ; 22a ; 22b ; 22c ; 22d) des éléments à étriers
- de la disposition des anneaux aimantés radiaux (14', 14") sur la surface intérieure du (/des) tambour(s) (12 ; 12', 12", 12"' ; 22a ; 22b ; 22c ; 22d)
- de la fixation des aimants axiaux (13', 13") et des pièces polaires sur le premier couvercle (11') et sur le deuxième couvercle (11") des éléments à étriers
- du déplacement des aimants axiaux (13', 13") fixés sur les couvercles (11', 11"), ensemble avec les pièces polaires, dans les anneaux aimantés radiaux (14', 14") respectifs, qui se trouvent en direction radiale à l'intérieur du (/des) tambour(s) (12 ; 12', 12", 12"' ; 22a ; 22b ; 22c ; 22d), de telle sorte que les couvercles (11', 11") reposent sur le (/les) tambour(s) cylindrique(s) creux (12 ; 12', 12'', 12"' ; 22a ; 22b ; 22c ; 22d) des éléments à étriers et les aimants axiaux (13', 13") soient placés au moins en partie dans une position définie, en direction radiale à l'intérieur des anneaux aimantés radiaux (14', 14").

14. Procédé selon la revendication 13, lors duquel, pour l'homogénéisation du champ magnétique, on bascule le premier couvercle (11') et/ou le deuxième couvercle (11") par rapport à l'axe z et/ou on le fait tourner autour de l'axe z.

15. Procédé selon la revendication 13 ou 14, lors duquel on monte les anneaux aimantés radiaux (14', 14") dans des positions prédéfinies par des saillies ou des échelons (12c) sur la face intérieure du (/des) tambour(s) cylindrique(s) creux (12 ; 12', 12", 12"' ; 22a ; 22b ; 22c ; 22d) .
